# EUROPEAN PATENT APPLICATION

(11) **EP 2 144 365 A1**
(43) Date of publication of application: **13.01.2010**
(21) Application number: 08160246.8
(22) Date of filing: 11.07.2008
(51) Int. Cl.: H03F 1/02

(54) **Device for amplifying signals with an envelope tracking technique or an envelope extraction and restoration technique controlled by a switched modulation**

(71) Applicant: Alcatel Lucent, 75008 Paris (FR)
(72) Inventor: Dartois, Luc, 78955 Carrières sous Poissy (FR)
(74) Representative: Korakis-Ménager, Sophie

(57) **Abstract**

A device (D) comprises i) a processing means (PM) arranged for applying either an envelope tracking technique or an envelope extraction and restoration technique to a digital input signal to produce an output RF signal, and ii) a switching means (SM) arranged for controlling said envelope tracking technique or envelope extraction and restoration technique by a switched modulation.

## Description

The present invention relates to power amplification of signals, notably in the domain of radio frequency (RF) transmissions.

As it is known from the man skilled in the art in some applications, such as wireless or cellular applications in the telecommunication domain, specialists try to render communication equipments cheaper and/or more compact. To this effect one may use cheap and/or compact RF power amplifiers. But such RF power amplifiers need also to keep a good electrical efficiency which is not easy.

Today Doherty RF power amplifiers are those offering the best electrical efficiency. But they are complex to polarize and tune and are not very broadband by nature.

To improve the situation, three other types of RF power amplifiers have been proposed.

The first type concerns RF power amplifiers implementing the so called envelope tracking (ET) technique. Regrettably RF power amplifiers of this first type encounters bandwidth limitations. These bandwidth limitations come mainly from the modulator and the trade off between the modulator bandwidth and its electrical efficiency, which leads to consumption by the modulator of a part of the energy gained by the improvements brought to the main amplifier.

The second type concerns RF power amplifiers implementing the so called envelope extraction and restoration (EER) technique. Also regrettably RF power amplifiers of this second type require a bandwidth in their restoration chain which is still more important than the one required by the first type RF power amplifiers. Moreover modulator techniques similar to the ones used today for ET technique do not permit an effective implementation at high bandwidth (100 MHz) and high power.

The third type concerns switched or class S RF power amplifiers. These third type RF power amplifiers are promising but they require very high transistors' and processing toggle frequency (especially in case of wireless applications where sampling frequency can be several times the RF carrier frequency). So it should take a long time before they could be used in applications requiring both high power and frequencies greater than 1 GHz.

So, the object of this invention is to improve the situation and notably to offer a RF power amplifier (or device) with an improved electrical efficiency.

More precisely, the invention provides a device comprising:
- a processing means arranged for applying either an envelope tracking technique (or scheme) or an envelope extraction and restoration technique (or scheme) to a digital input signal to produce an output RF signal, and
- a switching means arranged for controlling this envelope tracking technique or envelope extraction and restoration technique by a switched modulation.

The device according to the invention may include additional characteristics considered separately or combined, and notably:
- the digital input signals to be amplified may belong to a baseband frequency range or an intermediate frequency (IF) range;
- the processing means may comprise i) a local oscillator arranged for converting the RF output signal into an analog output signal at a chosen frequency, ii) an analog to digital converter arranged for converting the analog output signal into a digital output signal, iii) a predistortion means arranged for comparing the digital input signal with the digital output signal to determine non linearity therebetween and for compensating this non linearity on the digital input signal, and iv) a transposition means arranged for converting the digital input signal with compensated non linearity into a digital intermediate frequency signal with a chosen intermediate frequency;
   ➢ the processing means may comprise i) a digital to analog converter arranged for converting the digital intermediate frequency signal into an analog intermediate frequency signal, and ii) a local oscillator arranged for converting the analog intermediate frequency signal into an analog input signal to be amplified;
   ➢ the processing means may comprise an amplification means arranged for amplifying the power of the analog input signal under control of the switching means in order to deliver the output RF signal;
      • the amplification means may comprise at least one RF power transistor, for instance (and not limitative) either of the LDMOS type or of the GaN type;
   ➢ in case where the processing means applies an envelope tracking technique (or scheme), it may comprise i) a delay generation means arranged for applying a chosen delay, intended for synchronizing the switching means with the part of the processing means which is dedicated to amplification, to the digital input signal in order to output a delayed digital input signal, and ii) a detection means arranged for producing a delayed digital power signal representative of the power of the delayed digital input signal at a first frequency;
      • the processing means may comprise an equalizer arranged for filtering the delayed digital power signal before it feeds the switching means so as to compensate for imperfections (non flatness) of the transfer function of the switching means;
   ➢ in case where the processing means applies an envelope extraction and restoration technique (or scheme), the predistortion means may be arranged for producing a digital power signal representative of the power of the digital input signal with compensated non linearity at a first frequency, and for determining a chosen delay to apply to the digital power signal in order to synchronize the switching means with a part of the processing means which is dedicated to amplification. In this case the processing means comprises i) a delay generation means arranged for applying the determined chosen delay to the digital power signal to output a delayed digital power signal, and ii) an equalizer arranged for filtering the delayed digital power signal before it feeds the switching means;
   ➢ the switching means may comprise i) a clock means arranged for delivering a clock signal at a chosen first frequency (preferably with simple harmonic relation with the digital input sampling rate), and ii) a modulation means arranged for delivering a control signal representative of the delayed digital power signal with the same or approximately the same low frequency spectrum but at a second frequency greater than the first frequency;
      - the modulation means may comprise a sigma delta modulator or a pulse width modulator (PWM) or else a combination of both a sigma delta modulator and a pulse width modulator;
         o the sigma delta modulator may comprise a noise generation means arranged for defining a dithering signal based on the clock signal and for dithering the delayed power signal with this dithering signal before it feeds the modulator means (this is useful when signals to be amplified have bad statistical properties related to sigma delta principles);
   ➢ the switching means may comprise a RF supply switch arranged for delivering an analog supply signal varying with the control signal at the first frequency and intended for controlling the amplification means;
      - the RF supply switch may comprise at least one switching transistor, for instance either of the LDMOS type or of the GaN type;
      - the switching means may comprise a power supply arranged for supplying the RF supply switch with a DC voltage;
      - the switching means may comprise a low pass filter arranged for filtering the analog supply signal with minimal energy losses before it controls the amplification means;
         o the low pass filter may be a LC filter;
   ➢ the switching means may comprise a supply network of at least one diode arranged for feeding the amplification means with an analog comparison between the signal power and a lower supply voltage, so that when the RF supply switch or the low pass filter provides an instant higher voltage it becomes the only source of voltage and current for the amplification means;
      - the supply diode network may be located either before the low pass filter or after the low pass filter.

Other features and advantages of the invention will become apparent on examining the detailed specifications hereafter and the appended drawings, wherein:
- figure 1 schematically illustrates a first example of embodiment of a device according to the invention, implementing an envelope tracking technique (or scheme),
- figure 2 schematically illustrates a second example of embodiment of a device according to the invention, implementing an envelope extraction and restoration technique (or scheme), and
- figure 3 schematically illustrates an example of embodiment of a switching module comprising a supply diode network.

The appended drawings may serve not only to complete the invention, but also to contribute to its definition, if need be.

The invention aims at offering a device (D) having an improved electrical efficiency.

It is important to note that a device D according to the invention constitutes a power amplifier. Such a device D can be part of the transmission chain of a base station (or analogous communication equipment) of a wireless or cellular access network, for instance.

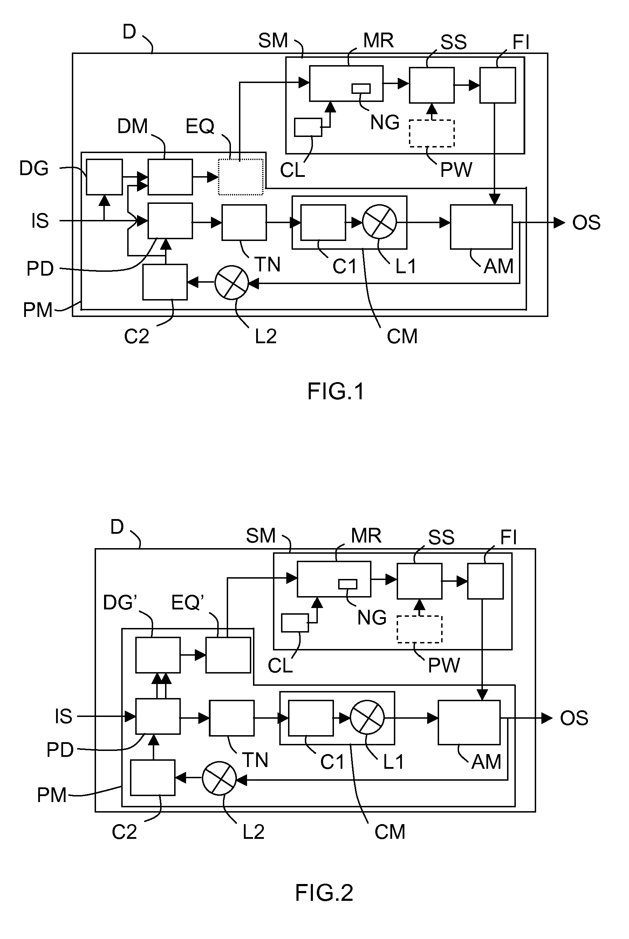

As schematically illustrated in figure 1 and 2, a device D according to the invention comprises a processing module PM and a switching module SM coupled one to the other.

The processing module PM is arranged for applying either an envelope tracking technique (or scheme) or an envelope extraction and restoration technique (or scheme) to a digital input signal IS to produce an output RF signal OS.

In the following description it will be considered that the digital input signals IS to be amplified belong to a baseband frequency range. But this is not mandatory. Indeed it can be also a low or medium intermediate frequency (IF) signal or a composite multicarrier signal with complex spectrum not centred to zero. For instance, this digital input signals IS is a composite I/Q baseband signal which may be sampled at 122.88 MSPS ("Mega Sample Per Second"). Moreover in the following description it will be considered that the device D produces RF output signals for a transmission chain of a base station working at 2.1 GHz with a 20 MHz band, for instance.

In the non limiting example of figure 1 the processing module PM implements an envelope tracking technique (or scheme), while in the non limiting example of figure 2 the processing module PM implements an envelope extraction and restoration technique (or scheme).

The switching module SM is arranged for controlling the envelope tracking (ET) technique or the envelope extraction and restoration (EER) technique by means of a switched (or class S) modulation.

In case where the processing module PM comprises an amplification module AM comprising at least one radio frequency (RF) power transistor, the control of the technique (or scheme) is preferably done by means of a modulation of the RF power transistor drain by the switching module SM. So, by combining a switching module SM, which implements a switched or class S modulation in baseband and not in RF, with a processing module PM, implementing an ET or EER technique, a device D combines the advantages offered by the ET technique or EER technique with some advantages offered by some elements of switched or class S power amplifiers to alleviate both limitations of each individual technique (respectively drain modulation speed and bandwidth limitations and the carrier frequency limitation).

In order to implement the ET technique or EER technique, and as illustrated in figures 1 and 2, the processing module PM may comprise a (well known) predistortion module PD, a transposition module TN, an analog to digital converter C2, and a local oscillator L2.

The local oscillator (or mixer) L2 comprises an input which is connected through a RF coupler (not shown) to the output of the amplification module AM (which delivers the RF output signal OS). This local oscillator L2 is arranged for converting the RF output signal OS into an analog output signal at a chosen frequency. This chosen frequency is preferably an intermediate high frequency so that baseband complex (I/Q) digital representation can be formed digitally to avoid any DC, gain and quadrature mismatch in the conversion, which is necessary for a good digital predistortion.

The analog to digital converter C2 comprises an input which is connected to the output of the local oscillator L2. This analog to digital converter C2 is arranged for converting the analog output signal provided by the local oscillator L2 into a digital output signal.

The predistortion module PD comprises a first input which receives the digital input signal IS to be amplified, and a second input which is connected to the output of the analog to digital converter C2. This predistortion module PD is arranged for comparing the received digital input signal IS provided by the analog to digital converter C2 with the digital output signal in order to determine non linearity therebetween, and then for compensating this non linearity on the digital input signal IS. So, it delivers onto a first output a digital input signal with compensated non linearity.

It is important to note that in the case of figure 2 the predistortion module PD delivers at least a digital input signal with compensated non linearity which is only representative of the input signal phase. In fact the predistortion module PD delivers two "predistorted" representations of the input signal: a first one being a constant envelope signal containing only signal phase information and a second one representing only the baseband envelope of the signal.

As it is known from the man skilled in the art the non linearity compensation can be carried out by means of an apprenticeship.

In the case of the device D illustrated in figure 2, the predistortion module PD is also arranged for producing a digital power signal representative of the power (or envelope) of the digital input signal with compensated non linearity, at a first frequency. In this case it is also arranged for determining a chosen delay that must be applied to the produced digital power signal in order to synchronize the processing module PM and the switching module SM. The synchronization consists in a temporal alignment of the main path (processing and amplification) and the switching path (SM). It is important to note that depending on the detailed implementation of the modulation and switching path (SM) and the main amplification path (PD, TN, CM, AM) of the processing module PM the digital delay has to be applied in the shortest path.

The transposition module TN comprises an input which is connected to the first output of the predistortion module PD. This transposition module TN is arranged for converting the digital input signal with compensated non linearity (provided by the first output of the predistortion module PD) into a digital intermediate frequency signal with a chosen intermediate frequency.

In the illustrated examples of embodiment, the processing module PM further comprises a conversion module CM intended for converting the digital intermediate frequency signal (delivered by the output of the transposition module TN) into an analog input signal to be amplified.

For instance and as illustrated, this conversion module CM comprises a digital to analog converter C1 and a local oscillator L1.

The digital to analog converter C1 comprises an input which is connected to the output of the transposition module TN. It is arranged for converting the digital intermediate frequency signal (delivered by the transposition module TN) into an analog intermediate frequency signal.

The local oscillator (or mixer) L1 comprises an input which is connected to the output of the digital to analog converter C1. It is arranged for converting the analog intermediate frequency signal into an analog input (RF) signal to be amplified.

As mentioned before, the processing module PM also comprises an amplification module AM comprising an input connected to the output of the local oscillator L1 and an output on which it delivers an output RF signal OS resulting from the amplification of the analog input signal under control of the switching module SM.

This amplification module AM comprises at least one RF power transistor which may be either of the LDMOS ("Laterally Diffused Metal Oxyde Semiconductor") type or of the GaN ("Gallium Nitride") type, for instance.

It is important to note that the amplification module AM may be preceded by one or more driver stages depending on the desired output power.

As mentioned before, the main amplification path (PD, TN, CM) of the processing module PM and the switching module SM are preferably synchronized (or temporally aligned) by means of a chosen integer or fractional delay. This delay can be determined during a factory calibration phase. But, it can be also determined by the predistortion module PD, notably in the case of figure 2 (EER technique), when a more accurate tuning is required. In this last case a delay determination can be done periodically during operation in order to compensate for some small delay drifts due to slow thermal conditions changes and/or aging, for instance. In any case the delay is preferably determined by a comparison between the phase and amplitude of the feedback signal and the reference input signal (IS), which is usually inherent to digital predistortion learning means.

In case of figure 1 the processing module PM comprises a delay generation module DG which receives the digital input signal IS and applies to the latter a chosen delay.

So, it delivers on its output a delayed digital input signal.

The delay can be statically calibrated or dynamically determined by means of delay and distortion measures made in the predistortion module PM while comparing the wanted signal power (or envelope) and phase with what is delivered by the device output (i.e. the RF output signal OS).

This delayed digital input signal feeds a detection module DM which is arranged for estimating its power (or envelope) at a first frequency (for instance 122.88 MSPS) and then for producing a delayed digital power signal which is representative of this power (or envelope) at the first frequency.

For instance this power (or envelope) estimation focuses onto the first 10-12 dB upper dynamic. This results from the fact that the spectrum bandwidth is symmetric around DC to 10 MHz for a 20 MHz output signal OS. The envelope spectrum is symmetric by nature, but one may focus on the upper part of the signal envelope dynamic when the power supply dynamic reduction brings significant power saving and efficiency increase in the amplifier AM.

The delayed digital power signal may be a digital voltage in the 10-12 dB dynamic, which represents approximately a factor 3 in voltage (15 V to 45 V for instance).

Moreover a minimal digital voltage value may be forced by the detection module DM when the estimated signal power is lower than a maximal output power-10 dB.

It is important to note that the power value may be compensated according to a parametric behaviour of the amplification module AM, for instance if the output of the latter is not exactly proportional to its drain voltage square. For instance the average RF output power can be compensated by means of a feedback loop on the amplification module output (it can be a part of the predistortion or it can be made by means of a fixed tabulated conversion of the raw envelope signal).

This estimated power feeds the switching module SM either directly or indirectly through an equalizer EQ of the processing module PM (as illustrated in the non limiting example of figure 1). This equalizer EQ is arranged for applying a chosen filtering (for instance by means of a low pass FIR digital filter with some preemphasis) to the received delayed digital power signal before it feeds the switching module SM. It is intended to compensate for imperfections (non flatness) of the transfer function of the switching module SM, and notably of the transfer function of the modulator MR (sigma delta converter and reconstruction filter), in the wanted 20 MHz band of the signal envelope.

In case of figure 2 the processing module PM comprises also a delay generation module DG, but the latter receives the power (or envelope) of the digital input signal with compensated non linearity from the predistortion module PD (delivered on a second output) and applies to it a chosen delay (that has been eventually determined by the predistortion module PD) at a first frequency. It delivers on its output a delayed digital power signal at the first frequency.

This delayed digital power signal feeds an equalizer EQ' of the processing module PM, which is arranged for applying a chosen filtering to the received delayed digital power signal before it feeds the switching module SM.

As illustrated, whatever the embodiment the switching module SM may comprise at least a clock module CL and a modulation module MR.

The clock module CL delivers a clock signal at the chosen first frequency.

The modulation module MR comprises a first input which receives the delayed (and possibly equalized) digital power signal and a second input which is coupled to the output of the clock module CL. It is arranged for producing a control signal which is representative of the received delayed (and possibly equalized) digital power signal, with the same or approximately the same low frequency spectrum but at a second frequency which is greater than the first frequency. In other words it over samples the received delayed (and possibly equalized) digital power signal. For instance it works at 3*122.88 MHz when the first frequency is equal to 122.88 MHz (or MSPS).

For instance the modulation module MR comprises a sigma delta modulator or a pulse width modulator (or PWM) or else a combination of both a sigma delta modulator and a pulse width modulator.

In case where the modulation module MR comprises a sigma delta modulator, the latter may comprise a noise generation module NG comprising an input coupled to the output of the clock module CL and arranged for defining a dithering signal based on the clock signal in order to dither the delayed power signal before it feeds the modulator MR. Such a noise generation module NG is notably useful when envelope statistics are not favourable, i.e. when the signal envelope has a significant periodic or pseudo periodic form. This noise generation module NG spreads the residual sigma delta inherent quantization noise and avoids its concentration at discrete spectral positions causing intermodulation like effects.

Such a dithering of the delayed power signal is intended for cleaning up the spectrum and distortion of the representation of the power (or envelope) from DC to about 15 MHz.

Preferably, in case where the device D is intended to be part of a base station (or analogous communication equipment) of a wireless or cellular access network, the value of the first frequency is chosen in order i) to be above the usual base station duplex spacing, ii) to offer a high enough ratio versus the highest signal power (or envelope) (in case of figure 1) or a high enough ratio versus the highest linearized bandwidth (in case of figure 2), iii) to be low enough to enable the use of low cost RF (VHF/UHF) power transistors with very high efficiency (not too much losses in parasitic gate-source, gate-drain or source-drain capacitances, for instance), iv) to allow simple harmonics of intermediate frequency, and v) to allow simple harmonics of the digital clock signal.

As illustrated, the switching module SM may further comprise a RF supply switch SS comprising an input connected to the output of the modulator MR (eventually through driver stages when the amount of power to switch requires it). This supply switch SS delivers an analog supply signal which varies with the received control signal (and therefore with the signal power (or envelope)) at the first frequency and which is intended for controlling the amplification module AM.

For instance the control signal is a binary sequence, which reproduces the signal power with the same spectrum but with the second frequency, and intended for controlling the supply switch SS so that its transistor(s) is (are) either blocked (i.e. with an infinite resistance) or saturated (i.e. with a RDSon of few tenths of milliOhm).

The RF supply switch SS may comprise at least one switching transistor. Each switching transistor may be of the same technology than the one used for the amplifier AM. So each switching transistor may be either of the LDMOS type or of the GaN type, for instance.

The RF supply switch SS feeds the amplifier AM with a drain voltage which is varying with the input signal power (or envelope), for instance in a 15 V - 45 V range and at the same frequency as the input signal power (or envelope) in order to enable the amplifier AM to work close to P1dB ("1 dB compression point") for all signal power (or envelope) position in the upper 10-12 dB.

The RF supply switch SS is preferably biased and controlled by the control signal to be always off or on so as to have dissipation only during transients.

For instance and as illustrated in the non limiting examples of figures 1 and 2, this RF supply switch SS is supplied with a DC voltage by a power supply PW of the switching module SM. It is important to note that it is possible to get rid of a serial power supply PW by using a RF supply switch SS comprising high voltage transistors and by regulating the amplifier gain. When the power supply output decreases (weaker power supply plant or discharging battery) one proportionally increases the digital value of the signal envelope at the modulator input. The sigma delta loop will then naturally increase the average time and number of "on" states of the RF supply switch SS, so regulating to the desired value the main amplifier drain voltage and keep away any amplifier derating behavior. In a variant one can regulate through a direct measurement and a comparison of the modulator reconstructed signal (at the output of the filter FI) with a desired modulator input (at the input of the equalizer EQ).

In the case of figure 1 and in case where the modulator MR is a sigma delta modulator, the voltage variation at the transistor source of the RF supply switch SS is preferably equal to the average ratio of the control signal delivered by the sigma delta modulator MR (i.e. from 1/3 to 1/1 if power supply PW delivers about 45 V).

The output of the supply switch SS may be connected to a control input of the amplifier AM either directly (for instance to a resistor drain) or indirectly through a low pass filter FI of the switching module SM as illustrated in the non limiting examples of figures 1 and 2. This low pass filter FI is arranged for filtering the analog supply signal before it controls the amplifier AM.

Such a low pass filter FI is preferably a LC filter, which can be made of serial coils and parallel capacitors with low losses and low parasitics, for instance.

This low pass filter FI aims at i) reproducing with a maximum flatness the band of power (or envelope) of the input signal (if there is a slope at higher frequency then equalizer EQ is preferably used in the device of figure 1), ii) suppressing the higher part of the power spectrum (dithering noise), iii) protecting the RF supply switch SS from main amplifier radio frequencies, iv) shaping the power (or envelope) to eliminate in the amplifier AM the sinC (sinus cardinal) switching harmonics that would disturb its behaviour, the predistortion module behaviour, and the base station transmission filter requirements, and possibly additional wideband noise that could fall in the reception band at duplex spacing.

It is important to note that in the case of figure 1, the filter FI does not need to pass more than half of the signal bandwidth (because it has a symmetric baseband part). Moreover, in the case of figure 2, the filter FI needs to pass about 5 times the bandwidth signal power (or envelope) in order to enable predistortion of the amplitude of the digital input signal IS. In the case of figure 1 the high bandwidth required for predistortion is still passing for envelope part in the main amplification path.

In case of figure 1, the amplifier AM may be of class A or B type because the analog input signal to be amplified still contains envelope information and as mentioned above also its predistortion bandwidth. It is important to note that in the upper part of the output power (∼10 dB) the reduction of the amplifier drain voltage makes it work close to P1dB.

In case of figure 2, the amplifier AM may be of class D, E or F because the analog input signal it receives is a phase signal only with constant envelope. So, acting as a phase amplifier it can be in saturated mode (even class S) because both itself and the "switched modulator" SM act together as a vector amplifier making together product of their respective signals. Even if it is not a perfect mathematical product, the predistortion process recovers part of the higher order polynomial products.

It is important to note that in order to still further improve the efficiency for the residual energy losses in the modulator MR, one may:
- reduce the switching rate and the associated losses in the RF supply switch SS (capacitive losses due to high rate of switching transients and capacitor charge/discharge) and time passed in conducting/saturated state with voltage drop due to RDSon high current for powering the amplifier AM,
- reduce cascading power supply regulating losses with the RF supply switch SS during time period where the powering voltage of the amplifier AM is at its lower value (15 V in the non limiting described example).

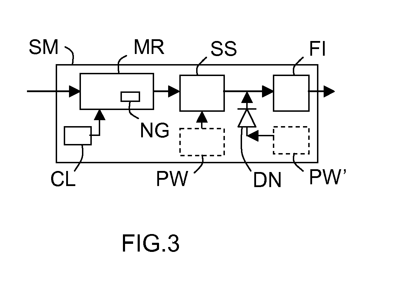

To this effect, one may feed the amplifier AM with an analog comparison of the greater transistor source voltage between the signal envelope and the lower supply voltage (here 15 V). As illustrated in the example of embodiment of figure 3, both amplifier transistor sources can be connected by a supply network DN of at least one diode, which is fed by an auxiliary power supply PW', so that when the RF supply switch SS or the filter FI provides an instant higher voltage it becomes the only source of voltage and current for the amplifier AM.

To avoid switching too much the RF supply switch SS during time periods where only a voltage of 15 V is needed and best provided by a classic constant regulated power source, the signal envelope to be generated should be ideally fixed to zero instead of 15 V. For this purpose one may replace (in the digital domain) 15 V equivalent samples by zero at the input of the modulator MR or equalizer EQ.

But due to its wide bandwidth nature, this punctured signal envelope has a distortion of some peaks after reconstruction and long time response of the modulator MR (by principle of embedded IIR), and one needs to shape preventively this punctured signal envelope for higher fidelity reproduction of the envelope peaks above 15 V when observed at the filter output (FI). This can be digitally done by building smooth ramp up and ramp down from 0 V to envelope peaks, either through tabulation, a dedicated filter or by inclusion into the equalizer features.

At least two variants of supply diode network DN can be envisaged either before the filter FI (as illustrated in figure 3) or after the filter FI.

In the non limiting example of a 15 V low voltage and a 45 V peak voltage the above mentioned improvements can reduce the average switching rate and related capacitive losses by a factor 2 to 4 depending on the envelope statistics.

The invention is not limited to the embodiments of device described above, only as examples, but it encompasses all alternative embodiments which may be considered by one skilled in the art within the scope of the claims hereafter.

## Claims

1. Device (D) for amplifying power of digital input signals, **characterized in that** it comprises i) a processing means (PM) arranged for applying either an envelope tracking technique or an envelope extraction and restoration technique to a digital input signal to produce an output RF signal, and ii) a switching means (SM) arranged for controlling said envelope tracking technique or envelope extraction and restoration technique by a switched modulation.

2. Device according to claim 1, wherein said digital input signal belongs to a baseband frequency range or an intermediate frequency range.

3. Device according to one of claims 1 and 2, wherein said processing means (PM) comprises i) a local oscillator (L2) arranged for converting said RF output signal into an analog output signal at a chosen frequency, ii) an analog to digital converter (C2) arranged for converting said analog output signal into a digital output signal, iii) a predistortion means (PD) arranged for comparing said digital input signal with said digital output signal to determine non linearity therebetween and for compensating said non linearity on said digital input signal, and iv) a transposition means (TN) arranged for converting said digital input signal with compensated non linearity into a digital intermediate frequency signal with a chosen intermediate frequency.

4. Device according to claim 3, wherein said processing means (PM) comprises i) a digital to analog converter (C1) arranged for converting said digital intermediate frequency signal into an analog intermediate frequency signal, ii) a local oscillator (L1) arranged for converting said analog intermediate frequency signal into an analog input signal to be amplified.

5. Device according to one of claims 3 and 4, wherein said processing means (PM) comprises an amplification means (AM) arranged for amplifying the power of said analog input signal under control of said switching means (SM) in order to deliver said output RF signal.

6. Device according to one of claims 3 to 5, wherein said processing means (PM) comprises i) a delay generation means (DG) arranged for applying a chosen delay, intended for synchronizing said switching means (SM) with a part of said processing means (PM) which is dedicated to amplification, to said digital input signal in order to output a delayed digital input signal, and ii) a detection means (DM) arranged for producing a delayed digital power signal representative of the power of said delayed digital input signal at a first frequency.

7. Device according to claim 6, wherein said processing means (PM) comprises an equalizer (EQ) arranged for filtering said delayed digital power signal before it feeds said switching means (SM) so as to compensate for imperfections of a transfer function of said switching means (SM).

8. Device according to one of claims 3 to 5, wherein said predistortion means (PD) is arranged for producing a digital power signal representative of the power of said digital input signal with compensated non linearity at a first frequency, and for determining a chosen delay to apply to said digital power signal in order to synchronize said switching means (SM) with a part of said processing means (PM) which is dedicated to amplification, and wherein said processing means (PM) comprises i) a delay generation means (DG') arranged for applying said determined chosen delay to said digital power signal to output a delayed digital power signal, and ii) an equalizer (EQ') arranged for filtering said delayed digital power signal before it feeds said switching means (SM).

9. Device according to one of claims 6 to 8, wherein said switching means (SM) comprises i) a clock means (CL) arranged for delivering a clock signal at a chosen first frequency, and ii) a modulation means (MR) arranged for delivering a control signal representative of said delayed digital power signal with a same or approximately a same low frequency spectrum but at a second frequency greater than said first frequency.

10. Device according to claim 9, wherein said modulation means (MR) comprises a sigma delta modulator and/or comprises a pulse width modulator.

11. Device according to claim 10, wherein said sigma delta modulator (MR) comprises a noise generation means (NG) arranged for defining a dithering signal based on said clock signal and for dithering said delayed power signal with said dithering signal before it feeds said modulator means (MR).

12. Device according to one of claims 9 to 11, wherein said switching means (SM) comprises a RF supply switch (SS) arranged for delivering an analog supply signal varying with said control signal at said first frequency and intended for controlling said amplification means (AM).

13. Device according to one of claims 5 and 12, wherein said amplification means (AM) and/or said RF supply switch (SS) comprise(s) at least one switching transistor.

14. Device according to one of claims 12 and 13, wherein said switching means (SM) comprises a power supply (PW) arranged for supplying said RF supply switch (SS) with a DC voltage.

15. Device according to one of claims 12 to 14, wherein said switching means (SM) comprises a low pass filter (FI) arranged for filtering said analog supply signal with minimal energy losses before it controls said amplification means (AM).

16. Device according to one of claims 5 to 15, wherein said switching means (SM) comprises a supply network (DN) of at least one diode arranged for feeding said amplification means (AM) with an analog comparison between said signal power and a lower supply voltage so that when said RF supply switch (SS) or said low pass filter (FI) provides an instant higher voltage it becomes the only source of voltage and current for said amplification means (AM).

17. Device according to claim 16, wherein said supply diode network (DN) is located either before said low pass filter (FI) or after said low pass filter (FI).
